# EUROPÄISCHE PATENTSCHRIFT

(11) **EP 1 528 679 B1**
(45) Veröffentlichungstag und Bekanntmachung des Hinweises auf die Patenterteilung: **15.01.2014**
(21) Anmeldenummer: 04021102.1
(22) Anmeldetag: 06.09.2004
(51) Int. Cl.: H03K 3/033

(54) **Elektrischer Impulsgenerator und Verfahren zum Erzeugen von kurzen elektrischen Impulsen**
Pulse generator and method for generating short pulses
Circuits d'impulsion et méthode pour générer des impulsions courtes

(30) Priorität: 26.09.2003 DE 10345077; 17.12.2003 DE 10359441
(43) Veröffentlichungstag der Anmeldung: 04.05.2005
(73) Patentinhaber: KROHNE MESSTECHNIK GMBH & CO. KG, 47058 Duisburg (DE)
(72) Erfinder: Gerding, Michael, 44623 Herne (DE); Schiek, Burkhard, 44801 Bochum (DE); Musch, Thomas, 45481 Mülheim en der Ruhr (DE)
(74) Vertreter: Gesthuysen Patent- und Rechtsanwälte

(56) Entgegenhaltungen:
- EP-A- 0 272 924
- US-A- 3 463 972
- US-A- 4 442 362
- ANONYMOUS: "Adjustable Pulse Width Single Shot. October 1965." IBM TECHNICAL DISCLOSURE BULLETIN, Bd. 8, Nr. 5, 1. Oktober 1965 (1965-10-01), Seite 817, XP002321270 New York, US
- KARDO-SYSOEV A F ET AL: "High repetition frequency power nanosecond pulse generation", PULSED POWER CONFERENCE, 1997. DIGEST OF TECHNICAL PAPERS. 1997 11TH I EEE INTERNATIONAL BALTIMORE, MA, USA 29 JUNE-2 JULY 1997, NEW YORK, NY, USA,IEEE, US, vol. 1, 29 June 1997 (1997-06-29), pages 420-424, XP010280232, DOI: 10.1109/PPC.1997.679366 ISBN: 978-0-7803-4213-2
- ZAZOUIIN S V ET AL: "High repetition frequency picosecond pulse generator", CONFERENCE RECORD OF THE 25TH INTERNATIONAL POWER MODULATOR SYMPOSIUM AND 2002 HIGH-VOLTAGE WORKSHOP. HOLLYWOOD, CA, JUNE 30 - JULY 3, 2002; [INTERNATIONAL POWER MODULATOR SYMPOSIUM], NEW YORK, NY : IEEE, US, 30 June 2002 (2002-06-30), pages 403-405, XP010636671, DOI: 10.1109/MODSYM.2002.1189501 ISBN: 978-0-7803-7540-6

## Beschreibung

Die Erfindung betrifft einen elektrischen Impulsgenerator, zum Erzeugen von kurzen elektrischen Impulsen sowie ein Verfahren zum Erzeugen von kurzen elektrischen Impulsen.

Bekannte elektrische Impulsgeneratoren sowie Verfahren zum Erzeugen kurzer elektrischer Impulse basieren zumeist auf der Verwendung von sogenannten Step-Recovery-Dioden (kurz: SRD) deren abruptes Ausschaltverhalten unter anderem zur Erzeugung kurzer elektrischer Impulse ausgenutzt wird. Ein Nachteil dabei ist die schwierige und technisch relativ aufwendige Trennung von anregendem Signal und erzeugtem Signal, da es sich bei einer Step-Recovery-Diode um ein Zweitorelement handelt. Weiterhin muß der Pegel des Ansteuersignals in der Größenordnung des gewünschten Ausgangspegels liegen, da mittels einer passiven Step-Recovery-Diode keine Signalsverstärkung möglich ist. Aufgrund der wenigen technischen Anwendungsgebiete von Step-Recovery-Dioden sind diese außerdem relativ schwer zu beschaffen und dementsprechend teuer.

Es ist die Aufgabe der Erfindung, einen elektrischen Impulsgenerator sowie ein Verfahren zum Erzeugen kurzer elektrischer Impulse anzugeben, die kostengünstig, unanfällig und vielseitig anwendbar sind.

Der elektrische Impulsgenerator, mit dem die zuvor hergeleitete und aufgezeigte Aufgabe gelöst ist, ist dadurch gekennzeichnet, daß vorgesehen sind: eine Ansteuereinrichtung zum Erzeugen eines Ansteuerimpulses, eine Transistorstufe mit einem Bipolartransistor, der der Ansteuerimpuls zugeführt wird und von der daraufhin unter Ausnutzung des Speicherschalteffekts des Bipolartransistors ein Ausgangssignal mit steiler Abschaltflanke ausgegeben wird, und eine Differenzierstufe, der das Ausgangssignal mit steiler Abschaltflanke zugeführt wird und von der daraufhin kurze Primärimpulse ausgegeben werden.

KARDO-SYSOEV A F ET AL, "High repetition frequency power nanosecond pulse generation" und ZAZOUIIN S V ET AL: "High repetition frequency picosecond pulse generator" offenbaren das Erzeugen von Nano- bzw. Picosekundenpulsen durch die Anwendung eines Drift-Step-Recovery Transistors, der zuerst von einem Rechteckimpuls angesteuert wird und dadurch in die Sättigung gebracht wird und anschliessend beim Verlassen des Sättigungszustandes zum Kollektorstromzusammenbruch getrieben wird.

US 3 463 972 offenbart eine Transistorstruktur mit besonderem Dotierungsprofil zur Ausnutzung des Step-Recovery Effekts.

Bei der Verwendung eines schnellen, hochfrequenten Bipolartransistors für die Transistorstufe sind kurze Impulse mit Impulsbreiten deutlich unter 1 ns bis unter 90 ps bei Amplituden von einigen Volt erreichbar. Zur Ausnutzung des Speicherschalteffekts des Bipolartransistors gilt dabei folgendes:

Der, vorzugsweise in Emitterschaltung betriebene, schnelle Bipolartransistor wird zunächst für eine kurze Zeit durch ein geeignetes Ansteuersignal in den Sättigungszustand gesteuert, so daß sowohl die Basis-Emitter-Diode als auch die Basis-Kollektor-Diode leitend werden. Die auf diese Weise mit Minoritätsladungsträgern überschwemmte und damit niederohmige Basis-Kollektor-Raumladungszone wird beim Abschalten des Transistoreingangssignals, vorliegend also des Ansteuerimpulses, nach kurzer Verzögerungszeit abrupt hochohmig, was zu einem abrupten Anstieg der Kollektorspannung führt. Bezogen auf das durch die Ansteuerschaltung erzeugte Transistoreingangssignal ist die Abschaltflanke des Transistorausgangssignals deutlich aufgesteilt, wobei die Polarität der aufgesteilten Abschaltflanke von dem verwendeten Transistortyp (NPN oder PNP), der Transistorgrundschaltung und der entsprechenden Polarität des Ansteuersignals abhängt.

Neben der hier aufgrund der hohen Stromverstärkung bevorzugten Emitterschaltung für den Bipolartransistor der Transistorstufe sind auch eine Kollektorschaltung oder eine Basisschaltung des Bipolartransistors möglich.

Mit dem zuvor beschriebenen elektrischen Impulsgenerator werden im allgemeinen elektrische Impulse mit bipolaren Anteilen erzeugt. Häufig ist jedoch ein Impulssignal mit rein monopolaren Anteilen gewünscht, so daß gemäß einer bevorzugten Weiterbildung der Erfindung eine Clipping-Einrichtung vorgesehen ist, die der Differenzierstufe nachgeschaltet ist und der die kurzen Primärimpulse zugeführt werden, wobei dabei aus den kurzen Primärimpulsen vorbestimmte Impulsanteile entfernt werden und ein kurzes Impulssignal ausgegeben wird. Insbesondere kann dabei eine solche Clipping-Einrichtung vorgesehen sein, mit der ein monopolares kurzes Impulssignal ausgegeben wird.

Für den Aufbau der Clipping-Einrichtung gibt es eine Vielzahl von Möglichkeiten. Gemäß bevorzugter Weiterbildungen der Erfindung ist dabei z. B. vorgesehen, daß eine seriell in die Leitung eingefügte Schottky-Diode, vorzugsweise mit einer geringen Gehäusekapazität, verwendet wird. Außerdem können in der Clipping-Einrichtung Transistoren, vorzugsweise HF-Transistoren, verwendet werden.

Als Ansteuerimpuls sind Impulse mit unterschiedlichen Impulsformen verwendbar. Gemäß einer bevorzugten Weiterbildung der Erfindung ist jedoch als Ansteuerimpuls ein Impuls vorgesehen, der im wesentlichen einem Rechteckimpuls entspricht und vorzugsweise eine Impulsbreite im Nanosekundenbereich aufweist.

In der Differenzierstufe können grundsätzlich alle bekannten Differenziertechniken verwendet werden. Gemäß einer bevorzugten Weiterbildung der Erfindung ist jedoch vorgesehen, daß die Differenzierstufe eine planare Schaltungsstruktur, vorzugsweise in Streifenleitertechnik, aufweist. Dabei kann die Funktion der Differenzierstufe dahingehend erweitert werden, daß zusätzlich zur Differenzierung eine Phasendrehung und somit eine Invertierung des Eingangssignals erfolgt. Dabei kann insbesondere eine solche planare Schaltungsstruktur vorgesehen sein, die eine Polaritätsumkehr bewirkt.

Gemäß einer bevorzugten Weiterbildung der Erfindung kann alternativ dazu die Differenzierstufe eine Transformatorschaltung aufweisen. Insbesondere kommt dabei auch in Betracht, daß die Transformatorschaltung mit gegenläufigem Wickelsinn versehen ist; so daß eine Polaritätsumkehr bewirkt wird.

Es sei darauf hingewiesen, daß in der Transistorstufe als Bipolartransistor insbesondere auch ein Heterostruktur-Bipolartransistor verwendet werden kann.

Schließlich ist zur weiteren Verkürzung des ausgegebenen Impulssignals gemäß einer bevorzugten Weiterbildung der Erfindung eine Mehrzahl von durch jeweils eine Clipping-Einrichtung getrennten Differenzierstufen vorgesehen. Mit dieser bevorzugten Weiterbildung der Erfindung lassen sich die Impulsbreiten nochmals weiter verringern, wobei allerdings eine Minderung der Amplitude in Kauf genommen werden muß.

Die weiter oben hergeleitete und aufgezeigte Aufgabe ist mit dem erfindungsgemäßen Verfahren zum Erzeugen von kurzen elektrischen Impulsen nach Patentanspruch 1.

Im einzelnen gibt es nun eine Vielzahl von Möglichkeiten, das erfindungsgemäße Verfahren zum Erzeugen von kurzen elektrischen Impulsen auszugestalten und weiterzubilden. Dazu wird auf den unabhängigen Patentanspruch 1 sowie auf die nachfolgende detaillierte Beschreibung bevorzugter Ausführungsbeispiele der Erfindung unter Bezugnahme auf die Zeichnung verwiesen. In der Zeichnung zeigt
- Fig. 1: ein Prinzipschaltbild eines elektrischen Impulsgenerators basierend auf einem NPN-Bipolartransistor gemäß einem ersten bevorzugten Ausführungsbeispiel der Erfindung,
- Fig. 2: ein Prinzipschaltbild eines Impulsgenerators basierend auf einem PNP-Transistor gemäß einem zweiten bevorzugten Ausführungsbeispiel der Erfindung,
- Fig. 3: verschiedene planare Realisierungsmöglichkeiten der Differenzierstufe gemäß unterschiedlicher bevorzugter Ausführungsbeispiele der Erfindung,
- Fig. 4: verschiedene Realisierungsmöglichkeiten der Differenzierstufe gemäß unterschiedlicher bevorzugter Ausführungsbeispiele der Erfindung und
- Fig. 5: ein Prinzipschaltbild für die Verwendung einer Mehrzahl von durch jeweils eine Clipping-Einrichtung getrennten Differenzierstufen gemäß einem weiteren bevorzugten Ausführungsbeispiel der Erfindung.

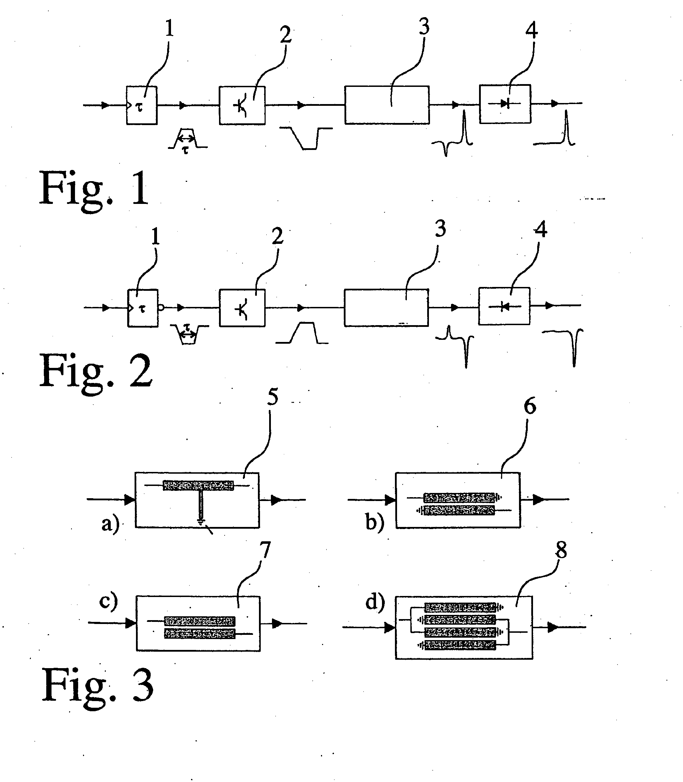

Aus Fig. 1 ist ein Prinzipschaltbild eines Impulsgenerators gemäß einem ersten bevorzugten Ausführungsbeispiel der Erfindung ersichtlich. Der Impulsgenerator weist eine Ansteuereinrichtung 1 zum Erzeugen eines Ansteuerimpulses auf, der im wesentlichen einem Rechteckimpuls mit einer Pulsbreite τ von einigen Nanosekunden entspricht. Dieser Ansteuerimpuls wird einer Transistorstufe 2 zugeführt, die einen NPN-Bipolartransistor in Emitterschaltung aufweist. Der Transistorstufe 2 nachgeschaltet ist eine Differenzierstufe 3, auf die schließlich eine Clipping-Einrichtung 4 folgt.

Es ist weiter oben schon angesprochen worden, daß der in der Transistorstufe 2 vorgesehene schnelle Bipolartransistor als Dreitorelement insofern vorteilhaft ist, als daß keine weiteren Vorkehrungen zur Trennung des Eingangsvom Ausgangssignal getroffen werden müssen, was den Schaltungsaufwand gegenüber einer Impulserzeugung mittels Step-Recovery-Diode erheblich reduziert. Im übrigen gilt, daß neben der für das vorliegende bevorzugte Ausführungsbeispiel der Erfindung ebenfalls möglichen Kollektorschaltung oder Basisschaltung des Bipolartransistors die Emitterschaltung aufgrund ihrer Stromverstärkung besser geeignet ist.

Zur Ausnutzung des Speicherschalteffekts des NPN-Bipolartransistors wird dieser zunächst für eine kurze Zeit in den Sättigungszustand gesteuert, so daß sowohl die Basis-Emitter-Diode als auch die Basis-Kollektor-Diode leitend werden. Damit wird die Basis-Kollektor-Raumladungszone mit Minoritätsladungsträgern überschwemmt und somit niederohmig. Beim Abschalten des Transistoreingangssignals, also des von der Ansteuereinrichtung 1 kommenden Ansteuerimpulses, wird die bisher niederohmige Basis-Kollektor-Raumladungszone nach kurzer Verzögerungszeit abrupt wieder hochohmig, was zu einem sehr schnellen Anstieg der Kollektorspannung führt. Gegenüber der Abschaltflanke des in den Transistor eingehenden Ansteuerimpulses wird die Abschaltflanke am Ausgang der Transistorstufe 2 deutlich aufgesteilt.

Wie ein Vergleich mit Fig. 2 ergibt, in der ein Prinzipschaltbild eines zu dem vorliegend beschriebenen Impulsgenerator komplementären Impulsgenerators mit einem PNP-Bipolartransistor in der Transistorstufe 2 gezeigt ist, ist die Polarität der aufgesteilten Abschaltflanke von dem verwendeten Transistortyp (NPN oder PNP) abhängig. Im übrigen hängt die Polarität der aufgesteilten Abschaltflanke, wie ebenfalls weiter oben schon angedeutet, von der verwendeten Transistorgrundschaltung sowie von der Ansteuerung des Transistors ab.

Gemäß der aus den Fig. 1 und 2 ersichtlichen bevorzugten Ausfübrungsbeispiele der Erfindung sind der Transistorstufe 2 jeweils eine Differenzierstufe 3 und eine Clipping-Einrichtung 4 nachgeschaltet, deren jeweilige Funktion sich wie folgt gestaltet:

Mit der Differenzierstufe 3 wird das von der Transistorstufe 2 kommende Ausgangssignal, das eine steile Abschaltflanke aufweist, differenziert, wozu die Differenzierstufe 3 in erster Linie Hochpaßcharakter aufweisen muß. Aus Fig. 3 sind unterschiedliche Realisierungsmöglichkeiten der Differenzierstufe 3 in Streifenleitertechnik gemäß bevorzugter Ausführungsbeispiele der Erfindung ersichtlich. Im Gegensatz zu den Netzwerken 5 und 7 gemäß Fig. 3a bzw. 3c bewirken die Netzwerke 6 und 8 gemäß Fig. 3b bzw. 3d zusätzlich zu der Differenzierung eine Phasendrehung des differenzierten Eingangssignals um 180°, was einer Polaritätsumkehr entspricht. Bei den Netzwerken 6, 7 und 8 gemäß den Fig. 3b, 3c bzw. 3d handelt es sich um für diesen Zweck optimierte Leitungskoppler, die je nach gewünschter Kopplung einzeln oder als Parallelschaltung mehrerer Leitungskoppler (Interdigitalkoppler) ausgeführt werden können. Die Dimensionierung der Netzwerke 5, 6, 7, und 8 bezüglich der Leitungsimpedanzen, Leitungslängen und der Verkopplung von Leitungen beeinflußt die resultierende Impulsbreite und Impulsamplitude. Da sich Aufbau und Funktion der in den Fig. 3a bis 3d gezeigten Netzwerke 5, 6, 7 und 8 für den Fachmann ohne weitere Erläuterungen ergeben, wird hier auf eine detaillierte Beschreibung verzichtet. Es sei lediglich darauf hingewiesen, daß die Netzwerke 5, 6 und 8 planare Strukturen mit teilweise gegen die Signalmasse kurzgeschlossenen Leitungen aufweisen, während dies bei Netzwerk 7 nicht vorgesehen ist.

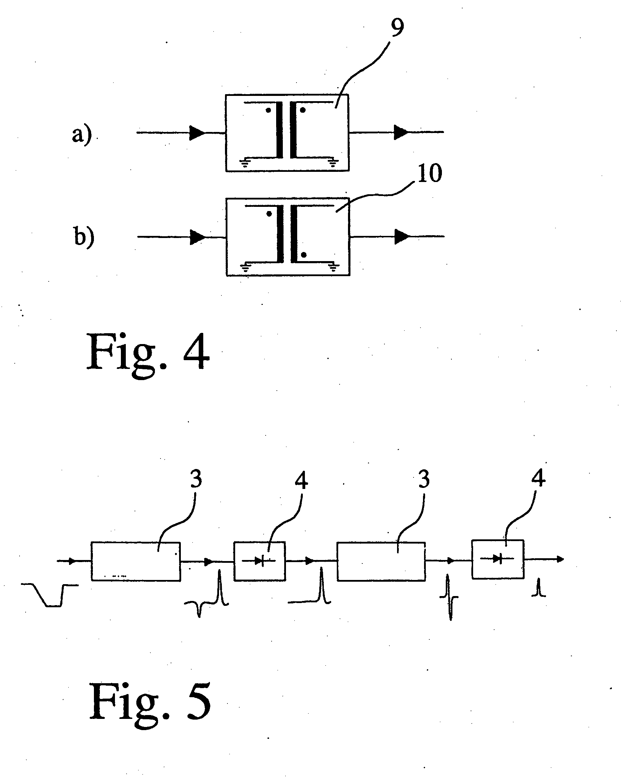

Neben den in Fig. 3 dargestellten planaren Strukturen 5, 6, 7 und 8 eignen sich als Differenzierstufen 3 auch Übertrager-Schaltungen 9 und 10, wie in den Fig. 4a und b dargestellt, wobei durch eine Transformatorschaltung mit gegenläufigem Wickelsinn eine Polaritätsumkehr bewirkt wird.

Des weiteren lassen sich für bestimmte Anwendungen die Differenzierstufen 3 gleichzeitig als Richtkoppler bzw. als Sende-Empfangsweiche auslegen. Die beiden durch die Differenzierung des von der Transistorstufe 2 herkommenden Ausgangssignals entstandenen Impulse weisen neben einer unterschiedlichen Polarität unterschiedliche Amplituden auf, was auf die unterschiedlichen Steigungen der Einschaltflanke bzw. der Ausschaltflanke des Ausgangssignals der Transistorstufe 2 zurückzuführen ist.

Mittels der jeweiligen Clipping-Einrichtung 4 kann z. B. ein einzelner Impuls aus den von der Differenzierstufe 3 ausgegebenen Primärimpulsen extrahiert werden. Gemäß einem bevorzugten Ausführungsbeispiel der Erfindung ist die Clipping-Einrichtung 4 durch eine seriell in die Leitung eingefügte Schottky-Diode realisiert, die je nach gewählter Polarität den entsprechenden Impuls clippt. Bei der Wahl der Schottky-Diode sollte unter anderem auf eine sehr geringe Gehäusekapazität geachtet werden, um ein kapazitives Übersprechen des geclippten Impulses zu verhindern. Als Clipping-Einrichtung 4 eignen sich auch verschiedene Varianten, die auf schnellen HF-Transistoren oder schnellen HF-tauglichen Dioden basieren und entweder seriell oder parallel in die Ausgangsleitung der Differenzierstufe 3 eingefügt sind.

Schließlich ist, wie gemäß dem in Fig. 5 gezeigten bevorzugten Ausführungsbeispiel der Erfindung ersichtlich, auch vorgesehen, mehrere Differenzierstufen 3 und Clipping-Einrichtungen 4 zu verketten, also eine Mehrzahl von durch jeweils eine Clipping-Einrichtung 4 getrennte Differenzierstufen 3 bereitzustellen. Eine solche Verkettung mehrerer Differenzierstufen 3 und Clipping-Einrichtungen 4 führt durch eine mehrfache Differenzierung des Impulssignals zu einer Verringerung der Impulsbreite. Aufgrund der in der Regel passiv realisierten Clipping-Einrichtungen 4 bewirkt eine solche Kettenschaltung jedoch auch eine Verringerung der Impulsamplitude.

Die mit der vorliegenden Erfindung realisierten Impulse werden in der Regel in eine Leitung, wie eine Streifenleitung oder eine Koaxialleitung mit einem definierten Wellenwiderstand eingespeist. Dementsprechend ist die Ausgangsimpedanz auf den Leitungswellenwiderstand der Leitung anzupassen. Bezogen auf ein 50 Ohm-System sind Impulsbreiten bis unter 90 ps und Amplituden von einigen Volt erreichbar.

Bezogen auf eine Spannungsamplitude von beispielsweise 5 V ergibt sich in einem 50 Ohm-System ein Strom von 100 mA und damit eine Momentanleistung von 500 mW. Gegenüber der herkömmlichen Impulserzeugung mittels Step-Recovery-Dioden, die ein der Ausgangsleistung entsprechendes Ansteuersignal erfordern, ist die Ansteuerleistung des vorliegend beschriebenen erfindungsgemäßen Impulsgenerators um ein Vielfaches geringer, so daß es z. B. möglich ist, mehrere Impulsgeneratoren mittels eines TTL-Signals parallel anzusteuern.

## Patentansprüche

1. Verfahren zum Erzeugen von kurzen elektrischen Impulsen, bei dem ein Ansteuerimpuls erzeugt wird, bei dem der Ansteuerimpuls als Transistoreingangssignal einem Bipolartransistor zugeführt wird und bei dem unter Ausnutzung des Speicherschalteffekts des Bipolartransistors der Bipolartransistor zunächst für eine kurze Zeit in den Sättigungszustand gesteuert wird, so dass beim Abschalten des dem Bipolartransistor als Transistoreingangssignal zugeführten Ansteuerimpulses von dem Bipolartransistor ein Transistorausgangssignal mit steiler Abschaltflanke erzeugt wird und die Abschaltflanke des Transistorausgangssignals deutlich aufgesteilt ist bezogen auf das Transistoreingangssignal,
**dadurch gekennzeichnet,**
**dass** das Transistorausgangssignal differenziert wird, daß der Bipolartransistor in Emitterschaltung betrieben wird,
**daß** mittels einer Clipping-Einrichtung, der das differenzierte Transistorausgangssignal zugeführt wird, aus dem differenzierten Transistorausgangssignal vorbestimmte Impulsanteile entfernt und kurze Impulssignale erzeugt werden, und
**daß** zur weiteren Verkürzung der kurzen Impulssignale eine Mehrzahl von Differenzierungen erfolgt und zwischen zwei aufeinanderfolgenden Differenzierungen jeweils ein vorbestimmter Impulsanteil aus dem kurzen Impulssignal entfernt wird.

## Claims

1. Method for generating short electric pulses, in which a control pulse is generated, in which the control pulse is fed to a bipolar transistor as transistor input signal and in which, when the charge storage effect of the bipolar transistor is used, the bipolar transistor is initially controlled in the saturation state for a short time, so that when the control pulses fed to the bipolar transistor as transistor input signals are stopped, a transistor output signal with a steep switch-off side is generated by the bipolar transistor and the switch-off side of the transistor output signal becomes steeper in respect to the transistor input signal,
**characterized in**
**that** the transistor output signal is differentiated,
**that** by means of a clipping device which is fed the differentiated transistor output signal, predetermined pulse parts are removed from the differentiated transistor output signal and short pulse signals are generated, and
**that** for further shortening of the short pulse signal, a plurality of differentiations are carried out and, between two successive differentiations, a predetermined part is removed from the short pulse signal.

## Revendications

1. Procédé pour générer des impulsions électriques courtes, dans lequel une impulsion de commande est générée, dans lequel l'impulsion de commande est appliquée en tant que signal d'entrée de transistor à un transistor bipolaire et dans lequel, en utilisant l'effet de commutation mémoire du transistor bipolaire, le transistor bipolaire est tout d'abord commandé pendant un court moment à l'état de saturation de sorte que lors de la coupure de l'impulsion de commande appliquée en tant que signal d'entrée de transistor au transistor bipolaire, un signal de sortie de transistor avec un flanc raide de mise hors circuit est généré par le transistor bipolaire et le flanc de mise hors circuit du signal de sortie de transistor est nettement plus raide compte tenu du signal d'entrée de transistor,
**caractérisé en ce que** le signal de sortie de transistor est différencié,
**en ce que** le transistor bipolaire est exploité en émetteur commun,
**en ce que**, à l'aide d'un dispositif d'écrêtage auquel le signal de sortie de transistor différencié est appliqué, on élimine du signal de sortie de transistor différencié des parties d'impulsion prédéterminées et génère des signaux impulsionnels courts, et
**en ce que**, pour encore raccourcir les signaux impulsionnels courts, une pluralité de différenciations est réalisée et **en ce que**, entre deux différenciations successives, on élimine respectivement une partie d'impulsion prédéterminée du signal impulsionnel court.
